# EUROPÄISCHE PATENTANMELDUNG

(11) **EP 4 730 481 A1**
(43) Veröffentlichungstag der Anmeldung: **22.04.2026**
(21) Anmeldenummer: 25204153.8
(22) Anmeldetag: 23.09.2025
(51) Int. Cl.: H01M 10/48, H01M 10/42, H01M 10/617, H01M 10/65, H01M 10/658, G01R 31/36

(54) **VERFAHREN ZUM PRÜFEN EINER BATTERIE UND BATTERIE-PRÜFVORRICHTUNG**

(30) Priorität: 19.10.2024 DE 102024130434
(71) Anmelder: autotherm Nenninger GmbH & Co. KG, 97631 Bad Königshofen (DE)
(72) Erfinder: KÖNIG, Manuel, 97616 Bad Neustadt (DE)
(74) Vertreter: Gosdin, Carstensen & Partner Patentanwälte Partnerschaftgesellschaft mbB

(57) **Zusammenfassung**

Die Erfindung betrifft ein Verfahren zum Prüfen einer Batterie (1), bei dem die Batterie (1) gemäß einer vorgegebenen Temperatur temperiert wird und dabei und/oder anschließend einer Funktionsprüfung unterzogen wird. Um es zu ermöglichen, in kurzer Zeit und mit geringem Energiebedarf eine zu prüfende Batterie auf eine gewünschte Temperatur zu bringen, sieht die Erfindung vor, dass zwecks Temperierung der Batterie (1) diese in einen Prüfblock (2) eingebracht wird und der Prüfblock (2) Mittel (3) zum Temperieren des Prüfblocks (2) aufweist, wobei die Mittel (3) zum Temperieren des Prüfblocks (2) mindestens ein Heizelement und mindestens ein Kühlelement umfassen, wobei der Prüfblock (2) einen Aufnahmeraum (4) für die Batterie (1) aufweist, a) wobei die Querschnittsfläche (A) des Aufnahmeraums (4) des Prüfblocks (2) der Querschnittsfläche (B) der Batterie (1) entspricht oder b) wobei die Batterie (1) in einem Adapter (5) aufgenommen ist, wobei der Adapter (5) einen Aufnahmeraum (6) für die Batterie (1) aufweist, wobei die Querschnittsfläche (D) des Aufnahmeraums (6) des Adapters (5) der Querschnittsfläche (B) der Batterie (1) entspricht und wobei die Querschnittsfläche (A) des Aufnahmeraums (4) des Prüfblocks (2) der Querschnittsfläche (C) des Adapters (5) entspricht.

## Beschreibung

Die Erfindung betrifft ein Verfahren zum Prüfen einer Batterie, insbesondere einer Batteriezelle, bei dem die Batterie gemäß mindestens einer vorgegebenen Temperatur oder einem vorgegebenen Temperaturverlauf temperiert wird und dabei und/oder anschließend einer Funktionsprüfung unterzogen wird. Des Weiteren betrifft die Erfindung eine Batterie-Prüfvorrichtung.

Batterien, wie sie beispielsweise und insbesondere in Elektrofahrzeugen zum Einsatz kommen, bestehen aus einzelnen Batteriezellen. Diese werden zu Modulen verschaltet und die Module wiederum zu Packs verbunden.

Die Batteriezellen können in verschiedenen Bauformen und Größen vorliegen. Teilweise sind hier auch genormte Größen vorgegeben (z. B. Pouchzellen, AA-Zellen, 18950-Zellen, zylindrische oder prismatische Zellen und Blockzellen).

Die Batterien bzw. Zellen, Module und Packs werden dabei im Rahmen der Produktion auch vorgegebenen Tests unterzogen, um die Funktion der Batterie zu prüfen. Hierbei geht es insbesondere um das Ladeverhalten, das Entladeverhalten, die Alterung sowie um das Verhalten der Batterie bei Temperaturänderungen. Hierzu ist es üblich, die Batterie bzw. die Zellen, Module und Packs in einer Klimakammer zu platzieren. Typische Abmessungen einer großen Klimakammer liegen bei einer Grundfläche von etwa 4 x 5 Metern. Die Klimakammer wird auf eine gewünschte Temperatur gebracht bzw. die Temperatur in der Klimakammer wird gemäß einem vorgegebenen Temperaturverlauf über der Zeit temperiert. Bereits dabei oder anschließend wird der entsprechende Test der Batterie vorgenommen. Die Klimakammer wird dabei von temperierter Luft durchströmt, so dass die Batterie die entsprechende Temperatur annimmt. Möglich ist es auch, dass die Batterie von innen über Temperierkanäle mit einem flüssigen Medium (wie beispielsweise Wasser, einer Wasser-Glykol-Mischung oder Öl) durchströmt werden; diese Medien sind gleichermaßen entsprechend temperiert. Einzelne Batteriezellen werden dagegen meist nur von außen mit Luft der Klimakammer umströmt; die Luftfeuchtigkeit spielt hier zumeist keine relevante Rolle. Während des Tests werden die Batterien in Zyklen oder konstant geladen, entladen und belastet, um die Funktionsfähigkeit zu prüfen.

Nachteilig ist bei vorbekannten Prüfverfahren für Batterien, dass für den gewünschten Temperaturbereich eine Klimakammer auf Temperaturen zwischen - 40 °C und + 85 °C, mitunter auch auf Temperaturen zwischen - 50 °C und + 300 °C, gebracht werden muss, wobei die sich in der Klimakammer befindliche Batterie durch Konvektion allmählich die Temperatur der Klimakammer annimmt. Hierdurch ist nicht nur ein relativ hoher Energiebedarf erforderlich; auch nimmt es eine gewisse Zeit in Anspruch, bis die zu prüfende Batterie die gewünschte Temperatur angenommen hat.

Der hohe Energiebedarf erklärt sich insbesondere durch die relativ hohen Massen der Bauteile der Klimakammer sowie der sonstigen Peripherie. Die benötigte Zeit ergibt sich dadurch, dass Luft als relativ schlechter Wärmeleiter den Prüfling nur allmählich temperiert.

Nachteilig ist im Übrigen, dass für die Klimakammer sowie die hier benötigte Peripherie viel Platz sowie ein hohes Investment benötigt werden.

Aus der DE 10 2022 106 507 A1 ist eine Testvorrichtung für eine Batterie bekannt, bei der ein Aufnahmeraum für die zu prüfende Batterie vorhanden ist, in welchen diese eingesetzt wird. Dabei wird von der Problematik ausgegangen, dass bei elektrochemischen Zellen im Falle einer mechanischen Beschädigung Kurzschlüsse stattfinden können, durch welche brennbare Gase, Flüssigkeiten und feste Bestandteile aus der elektrochemischen Zelle austreten können. Zur diesbezüglichen verbesserten Prüfung einer Batterie schlägt das Dokument den Einsatz eines "mechanischen Elements", beispielsweise in Form eines Nagels, der in die Batterie eingedrückt wird, vor, mit dem der genannte Fehlerfall simuliert werden kann.

Der Erfindung liegt die **Aufgabe** zugrunde, ein Verfahren der eingangs genannten Art so fortzubilden, dass es möglich wird, in kurzer Zeit und mit geringem Energiebedarf eine zu prüfende Batterie auf eine gewünschte Temperatur zu bringen bzw. gemäß einem vorgegebenen Temperaturprofil zu temperierten. Ferner soll der apparative Aufwand hierfür möglichst geringgehalten werden, wozu insbesondere eine entsprechende Prüfvorrichtung vorgeschlagen werden soll. Dabei wird weiterhin angestrebt, die Prüfung der Batterie in umfassender Weise vornehmen zu können, so dass alle infrage kommenden Prüfanforderungen erfüllt werden können.

Die **Lösung** dieser Aufgabe durch die Erfindung ist verfahrensgemäß dadurch gekennzeichnet, dass zwecks Temperierung der Batterie diese in einen Prüfblock eingebracht wird und der Prüfblock Mittel zum Temperieren des Prüfblocks aufweist, wobei die Mittel zum Temperieren des Prüfblocks mindestens ein Heizelement und mindestens ein Kühlelement umfassen, wobei mit den Mitteln zum Temperieren die vorgegebene Temperatur oder der vorgegebene Temperaturverlauf gesteuert oder geregelt wird, wobei der Prüfblock mindestens einen Aufnahmeraum für die Batterie aufweist, wobei der Aufnahmeraum eine Längsachse und eine Querschnittsfläche senkrecht zur Längsachse aufweist, wobei die Batterie eine Längsachse und eine Querschnittsfläche senkrecht zur Längsachse aufweist,
a) wobei die Querschnittsfläche des Aufnahmeraums des Prüfblocks der Querschnittsfläche der Batterie entspricht oder
b) wobei die Batterie in einem Adapter aufgenommen ist, wobei der Adapter eine Längsachse und eine Querschnittsfläche senkrecht zur Längsachse aufweist, wobei der Adapter einen Aufnahmeraum für die Batterie mit einer Längsachse und einer Querschnittsfläche senkrecht zur Längsachse aufweist, wobei die Querschnittsfläche des Aufnahmeraums des Adapters der Querschnittsfläche der Batterie entspricht und wobei die Querschnittsfläche des Aufnahmeraums des Prüfblocks der Querschnittsfläche des Adapters entspricht.

Bei der Funktionsprüfung verbleibt zwischen der Batterie und dem Aufnahmeraum des Prüfblocks vorzugsweise ein Luftspalt, der, gemessen senkrecht zur Längsachse des Aufnahmeraums, geringer ist als 2,0 mm, vorzugsweise geringer ist als 1,0 mm. Dies gilt, wenn die Batterie unmittelbar im Aufnahmeraum des Prüfblocks angeordnet ist (obiger Fall a).

Im anderen Falle (obiger Fall b) ist bevorzugt vorgesehen, dass bei der Funktionsprüfung zwischen der Batterie und dem Aufnahmeraum des Adapters ein Luftspalt verbleibt, der, gemessen senkrecht zur Längsachse des Adapters, geringer ist als 2,0 mm, vorzugsweise geringer ist als 1,0 mm, und dass zwischen dem Adapter und dem Aufnahmeraum des Prüfblocks ein Luftspalt verbleibt, der, gemessen senkrecht zur Längsachse des Aufnahmeraums im Prüfblock, geringer ist als 2,0 mm, vorzugsweise geringer ist als 1,0 mm.

Eine mögliche Ausführungsform der Erfindung sieht vor, dass bei der Funktionsprüfung der genannte Luftspalt mit einem Wärmeträger gefüllt wird; bei diesem handelt es sich insbesondere um eine Flüssigkeit. Als Flüssigkeit kann bevorzugt Wasser oder Öl vorgesehen werden. Wird der genannte Wärmeträger, insbesondere also die Flüssigkeit, eingesetzt, ist es sinnvoll, den Prüfblock so anzuordnen, dass sich die Aufnahmeräume für die Batterie bzw. die Batteriezelle in vertikaler Richtung erstrecken. Die zu prüfenden Batterien bzw. Batteriezellen werden dann von oben in ihre jeweiligen Aufnahmeräume eingeschoben.

Die vorgeschlagene Batterie-Prüfvorrichtung zeichnet sich erfindungsgemäß dadurch aus, dass sie einen Prüfblock umfasst, welcher mit Mitteln zum Temperieren des Prüfblocks versehen ist, die zum Temperieren des Prüfblocks auf eine vorgegebene Temperatur oder gemäß einem vorgegebenen Temperaturverlauf geeignet sind, wobei die Mittel zum Temperieren des Prüfblocks mindestens ein Heizelement und mindestens ein Kühlelement umfassen, wobei der Prüfblock mindestens einen Aufnahmeraum für die Batterie aufweist, wobei der Aufnahmeraum eine Längsachse und eine Querschnittsfläche senkrecht zur Längsachse aufweist, wobei die Batterie eine Längsachse und eine Querschnittsfläche senkrecht zur Längsachse aufweist, und
a) wobei die Querschnittsfläche des Aufnahmeraums der Querschnittsfläche der Batterie entspricht oder
b) wobei die Vorrichtung weiterhin einen Adapter umfasst, welcher zur Aufnahme der Batterie ausgebildet ist, wobei der Adapter eine Längsachse und eine Querschnittsfläche senkrecht zur Längsachse aufweist, wobei der Adapter einen Aufnahmeraum für die Batterie mit einer Längsachse und einer Querschnittsfläche senkrecht zur Längsachse aufweist, wobei die Querschnittsfläche des Aufnahmeraums des Adapters der Querschnittsfläche der Batterie entspricht und wobei die Querschnittsfläche des Aufnahmeraums des Prüfblocks der Querschnittsfläche des Adapters entspricht.

Der Prüfblock besteht dabei bevorzugt aus einem gut temperaturleitenden Material, insbesondere aus Kupfer, Aluminium oder Stahl (Edelstahl).

Gleichermaßen ist es bevorzugt, dass ein zum Einsatz kommender Adapter aus einem gut temperaturleitenden Material, insbesondere aus Kupfer, Aluminium oder Stahl (Edelstahl), gefertigt ist.

Die Mittel zum Temperieren des Prüfblocks umfassen bevorzugt Kanäle, die in den Prüfblock eingearbeitet sind und welche zum Durchströmen mit einem temperierten Fluid ausgebildet sind.

Möglich ist es aber auch, dass die Mittel zum Temperieren des Prüfblocks Heizelemente und Kühlelemente umfassen, die im Prüfblock eingesetzt sind.

Die Heizelemente sind in diesem Falle bevorzugt elektrische Heizstäbe. Die Kühlelemente können als Peltier-Elemente ausgebildet sein.

Gemäß einer bevorzugten Ausführungsform ist nicht nur mindestens ein Heizelement und mindestens ein Kühlelement vorgesehen, sondern jeweils mehrere Heizelemente und mehrere Kühlelemente.

Der Prüfblock kann zumindest teilweise von Isolationsmaterial umgeben sein.

Eine spezielle Ausführungsform der Erfindung sieht vor, dass im Prüfblock abgegrenzte Regionen ausgebildet sind, die unterschiedlich temperiert werden können. Hiernach weist die Batterie-Prüfvorrichtung dann mindestens zwei Aufnahmeräume im Prüfblock auf, welche thermisch voneinander isoliert sind.

Das vorgeschlagene Verfahren bzw. die zugehörige Batterie-Prüfvorrichtung stellt demgemäß im Kern darauf ab, dass im Vergleich zu einer Klimakammer ein relativ kleiner Prüfblock vorgesehen wird, welcher gemäß den thermischen Anforderungen temperiert wird.

Wesentlich ist dabei, dass eine effektive Prüfung der Batterie erfolgen kann, da ein breites Temperaturspektrum von sehr niedrigen bis sehr hohen Temperaturen durchfahren werden kann. Bewerkstelligt wird dies durch die Anordnung sowohl mindestens eines Heizelements als auch mindestens eines Kühlelements im Prüfblock. Da bekanntlich eine Batterie insbesondere bei niedrigen Temperaturen in ihrer Leistungsfähigkeit stark nachlassen kann, können mit dem erfindungsgemäßen Vorschlag auch niedrige Temperaturbereiche gezielt gefahren und die Batterie bei diesen geprüft werden.

In die Aufnahmekammer im Prüfblock wird passgenau (d. h. mit nur minimalem Luftspalt) die zu prüfende Batterie entweder direkt eingesetzt; alternativ kann die Batterie zunächst passgenau in den Aufnahmeraum des Adapters eingesetzt werden, der dann wiederum passgenau in die Aufnahmekammer im Prüfblock eingeschoben wird.

Zur Erhöhung der Sicherheit der Anlage bei der Prüfung der Batterie (z. B. bedingt durch ein Ausgasen einer Batteriezelle im Havariefall) kann ein Gehäuse mit entsprechender Sicherheitssensorik (Gassensoren, Abluftsystem, usw.) vorgesehen werden.

Mit der vorgeschlagenen Lösung ist es möglich, ein Umtemperieren der Batterie bzw. einer Batteriezelle schnell und mit geringem Energieaufwand zu realisieren, so dass die zu prüfende Batterie eine vorgegebene Temperatur hat. Auf den Einsatz einer Klimakammer, wie im Stand der Technik üblich, kann verzichtet werden, was den Energieaufwand für die Temperierung der Batterie wesentlich reduziert.

Durch Vorsehen entsprechender unterschiedlicher Adapter wird es somit möglich, geometrisch unterschiedlich gestaltete Batterien in den Prüfblock einzusetzen und zu prüfen.

Damit ein schneller Wärmeübergang vom Prüfblock (gegebenenfalls über den Adapter) zur Batterie erfolgt, sind die Mittel zur Temperierung des Prüfblocks möglichst nahe an den Aufnahmeräumen des Prüfblocks angeordnet.

Gegebenenfalls gewünschte Sicherheitselemente (insbesondere ein entsprechendes Gehäuse) kann mit geringem Aufwand um den Prüfblock platziert werden, um für den Fall des Berstens einer Batterie gewappnet zu sein.

In vorteilhafter Weise kann somit mit geringem Energiebedarf eine Prüfung der präzise temperierten Batterie vorgenommen werden. Vorteilhaft ist weiterhin, dass ein schnelles Umtemperieren der Batterie erfolgen kann, sofern dies die Prüfvorschrift fordert.

Die Investitionskosten für die Vorrichtung sind relativ gering, gleichermaßen auch der Platzbedarf.

Es besteht eine einfache Anschlussmöglichkeit der Elektronik, die zur Prüfung der Batterie erforderlich ist.

Auch können in relativ einfacher Weise durch ein Gehäuse Sicherheitsanforderungen erfüllt werden.

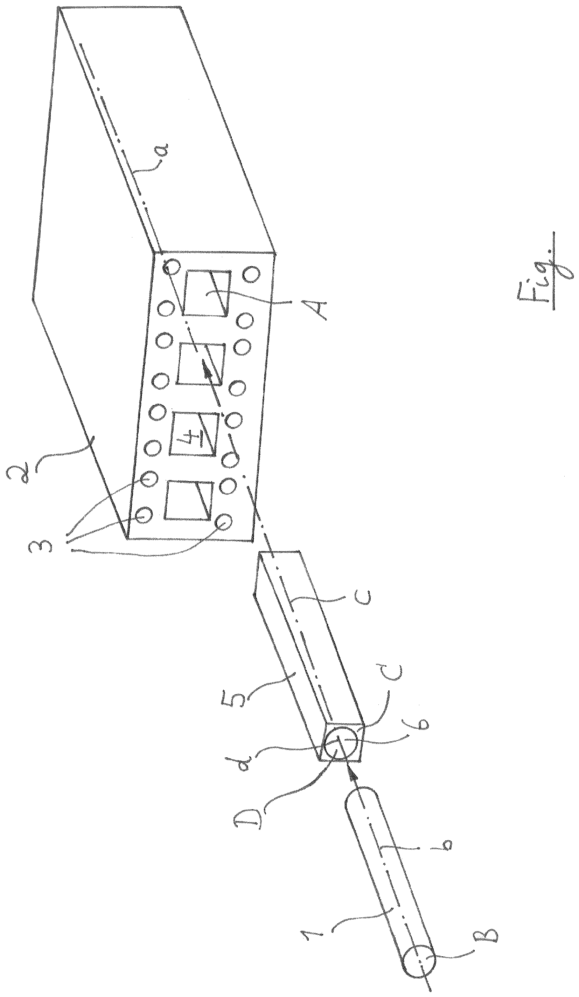

In der Zeichnung ist ein Ausführungsbeispiel der Erfindung dargestellt. Die einzige Figur zeigt in Explosionsdarstellung einen Prüfblock sowie eine in diesem zu prüfende Batterie, welche mittels eines Adapters im Prüfblock angeordnet ist.

In der Figur ist eine Batterie-Prüfvorrichtung mit den im Zusammenhang mit der vorliegenden Lösung relevanten Elementen skizziert. Zentraler Teil der Prüfvorrichtung ist ein Prüfblock 2, der eine Anzahl von Aufnahmeräumen 4 aufweist. Die Aufnahmeräume 4 sind im Ausführungsbeispiel im Querschnitt quadratisch ausgebildet. Jeder Aufnahmeraum 4 hat eine Längsachse a und eine Querschnittsfläche A, betrachtet senkrecht zur Längsachse a.

Der Prüfblock 2 verfügt über Mittel 3 zum Temperieren des Prüfblocks 2. Diese Mittel können als Kanäle im Inneren des Prüfblocks 2 ausgebildet sein, welche von einem temperierten Fluid durchströmt werden und so den Prüfblock 2 auf eine gewünschte Temperatur bringen. Da der Prüfblock 2 bevorzugt aus einem sehr gut wärmeleitenden Material (z. B. Kupfer) besteht, nimmt er schnell die Temperatur des Fluids an, insbesondere nahe den Wandungen der Aufnahmeräume 4. Zu diesem Zweck sind die Kanäle möglichst nahe an den Wandungen angeordnet.

Der Prüfblock 2 besteht bevorzugt aus einem massiven Teil, in welches die Aufnahmeräume 4 eingearbeitet sind.

In der Prüfvorrichtung soll eine Batterie 1 geprüft werden, welche eine Längsachse b sowie Querschnittsfläche B aufweist, die senkrecht zur Längsachse b zu verstehen ist.

Im Prinzip wird die Batterie 1 (in Pfeilrichtung) in einen Aufnahmeraum 4 im Prüfblock 2 eingeschoben. Dies erfolgt passgenau, d. h. unter Verbleib eines nur minimalen (Luft-)Spalts. Der Spalt beträgt dabei bevorzugt weniger als 1 mm.

Somit ist ein schneller und effizienter Wärmeübergang vom Prüfblock 2 auf die Batterie 1 gegeben, so dass diese für eine durchzuführende Prüfung die gewünschte Temperatur bzw. einen gewünschten Temperaturverlauf über der Zeit hat.

Im Ausführungsbeispiel gemäß der Figur ist allerdings eine alternative Lösung dargestellt, bei der ein Adapter 5 zum Einsatz kommt. Der Adapter weist, wie die Batterie 1, eine längliche Form mit einer Längsachse c auf und hat senkrecht zu dieser eine Querschnittsfläche C. Ferner hat der Adapter einen Aufnahmeraum 6, der gleichermaßen eine Längsachse d und senkrecht zu dieser eine Querschnittsfläche D aufweist.

Die Batterie 1 hat im Ausführungsbeispiel jedoch eine runde Querschnittsfläche B, während die Querschnittsfläche A des Aufnahmeraums 4 im Prüfblock 2 quadratisch ist. Der Adapter 5 dient zum Ausgleich dieser geometrischen Unterschiede.

Wiederum gilt nämlich, dass bei eingeschobener Batterie 1 in den Aufnahmeraum 6 im Adapter 5 Passgenauigkeit vorliegt, d. h. nur ein minimaler Luftspalt zwischen Batterie 1 und Adapter 5 verbleibt. Gleichermaßen ist die Querschnittsfläche C des Adapters 5 kongruent zur Querschnittsfläche A des Aufnahmeraums 4 im Prüfblock 2 gestaltet, so dass auch hier nur ein minimaler Spalt zwischen Aufnahmeraum 4 und Adapter 5 vorliegt, wenn letzterer in den Aufnahmeraum 4 im Prüfblock 2 eingeschoben ist.

Da sowohl der Prüfblock 2 als auch der Adapter 5 aus gut wärmeleitendem Material bestehen, erfolgt ein schneller Wärmeübergang vom Prüfblock 2 auf die Batterie 1, so dass diese zwecks Prüfung die gewünschte Temperatur bzw. den gewünschten Temperaturverlauf aufweist.

Die vorgeschlagene Prüfvorrichtung eignet sich besonders gut für Feststoff-Batterien, insbesondere Lithium-Ionen-Batterien.

Angemerkt sei noch, dass die Begrifflichkeit der Längsachse von Batterie 1, Adapter 5 und Prüfblock 2 natürlich nur insofern allgemein zu verstehen ist, als dass eine Einschubrichtung der Batterie in den Adapter oder in den Prüfblock bzw. des Adapters in den Prüfblock hierdurch definiert werden soll und keine Aussagen darüber getroffen werden, wie lang die Abmessung der genannten Komponenten in Längsrichtung im Verhältnis zu den anderen Abmessungen sind.

### Bezugszeichenliste:

- 1: Batterie / Batteriezelle
- 2: Prüfblock
- 3: Mittel zum Temperieren des Prüfblocks
- 4: Aufnahmeraum im Prüfblock
- 5: Adapter
- 6: Aufnahmeraum im Adapter

- a: Längsachse des Aufnahmeraums im Prüfblock
- b: Längsachse der Batterie
- c: Längsachse des Adapters
- d: Längsachse des Aufnahmeraums im Adapter

- A: Querschnittsfläche des Aufnahmeraums im Prüfblock
- B: Querschnittsfläche der Batterie
- C: Querschnittsfläche des Adapters
- D: Querschnittsfläche des Aufnahmeraums im Adapter

## Patentansprüche

1. Verfahren zum Prüfen einer Batterie (1), insbesondere einer Batteriezelle, bei dem die Batterie (1) gemäß mindestens einer vorgegebenen Temperatur oder einem vorgegebenen Temperaturverlauf temperiert wird und dabei und/oder anschließend einer Funktionsprüfung unterzogen wird,
**dadurch gekennzeichnet,**
**dass** zwecks Temperierung der Batterie (1) diese in einen Prüfblock (2) eingebracht wird und der Prüfblock (2) Mittel (3) zum Temperieren des Prüfblocks (2) aufweist, wobei die Mittel (3) zum Temperieren des Prüfblocks (2) mindestens ein Heizelement und mindestens ein Kühlelement umfassen, wobei mit den Mitteln (3) zum Temperieren die vorgegebene Temperatur oder der vorgegebene Temperaturverlauf gesteuert oder geregelt wird,
wobei der Prüfblock (2) mindestens einen Aufnahmeraum (4) für die Batterie (1) aufweist, wobei der Aufnahmeraum (4) eine Längsachse (a) und eine Querschnittsfläche (A) senkrecht zur Längsachse (a) aufweist,
wobei die Batterie (1) eine Längsachse (b) und eine Querschnittsfläche (B) senkrecht zur Längsachse (b) aufweist,
a) wobei die Querschnittsfläche (A) des Aufnahmeraums (4) des Prüfblocks (2) der Querschnittsfläche (B) der Batterie (1) entspricht oder
b) wobei die Batterie (1) in einem Adapter (5) aufgenommen ist, wobei der Adapter (5) eine Längsachse (c) und eine Querschnittsfläche (C) senkrecht zur Längsachse (c) aufweist, wobei der Adapter (5) einen Aufnahmeraum (6) für die Batterie (1) mit einer Längsachse (d) und einer Querschnittsfläche (D) senkrecht zur Längsachse (d) aufweist, wobei die Querschnittsfläche (D) des Aufnahmeraums (6) des Adapters (5) der Querschnittsfläche (B) der Batterie (1) entspricht und wobei die Querschnittsfläche (A) des Aufnahmeraums (4) des Prüfblocks (2) der Querschnittsfläche (C) des Adapters (5) entspricht.

2. Verfahren nach Anspruch 1, **dadurch gekennzeichnet, dass** bei der Funktionsprüfung zwischen der Batterie (1) und dem Aufnahmeraum (4) des Prüfblocks (2) ein Luftspalt verbleibt, der, gemessen senkrecht zur Längsachse (a) des Aufnahmeraums (4), geringer ist als 2,0 mm, vorzugsweise geringer ist als 1,0 mm.

3. Verfahren nach Anspruch 1, **dadurch gekennzeichnet, dass** bei der Funktionsprüfung zwischen der Batterie (1) und dem Aufnahmeraum (6) des Adapters (5) ein Luftspalt verbleibt, der, gemessen senkrecht zur Längsachse (c) des Adapters (5), geringer ist als 2,0 mm, vorzugsweise geringer ist als 1,0 mm, und dass zwischen dem Adapter (5) und dem Aufnahmeraum (4) des Prüfblocks (2) ein Luftspalt verbleibt, der, gemessen senkrecht zur Längsachse (a) des Aufnahmeraums (4) im Prüfblock (2), geringer ist als 2,0 mm, vorzugsweise geringer ist als 1,0 mm.

4. Verfahren nach Anspruch 2 oder 3, **dadurch gekennzeichnet, dass** bei der Funktionsprüfung der Luftspalt mit einem Wärmeträger gefüllt wird, insbesondere mit einer Flüssigkeit.

5. Verfahren nach Anspruch 4, **dadurch gekennzeichnet, dass** als Flüssigkeit Wasser oder Öl verwendet wird.

6. Batterie-Prüfvorrichtung für eine Batterie (1), insbesondere für eine Batteriezelle, insbesondere zur Durchführung des Verfahrens nach einem der Ansprüche 1 bis 5,
**dadurch gekennzeichnet,**
**dass** sie einen Prüfblock (2) umfasst, welcher mit Mitteln (3) zum Temperieren des Prüfblocks (2) versehen ist, die zum Temperieren des Prüfblocks (2) auf eine vorgegebene Temperatur oder gemäß einem vorgegebenen Temperaturverlauf geeignet sind, wobei die Mittel (3) zum Temperieren des Prüfblocks (2) mindestens ein Heizelement und mindestens ein Kühlelement umfassen, wobei der Prüfblock (2) mindestens einen Aufnahmeraum (4) für die Batterie (1) aufweist, wobei der Aufnahmeraum (4) eine Längsachse (a) und eine Querschnittsfläche (A) senkrecht zur Längsachse (a) aufweist, wobei die Batterie (1) eine Längsachse (b) und eine Querschnittsfläche (B) senkrecht zur Längsachse (b) aufweist, und
a) wobei die Querschnittsfläche (A) des Aufnahmeraums (4) der Querschnittsfläche (B) der Batterie (1) entspricht oder
b) wobei die Vorrichtung weiterhin einen Adapter (5) umfasst, welcher zur Aufnahme der Batterie (1) ausgebildet ist, wobei der Adapter (5) eine Längsachse (c) und eine Querschnittsfläche (C) senkrecht zur Längsachse (c) aufweist, wobei der Adapter (5) einen Aufnahmeraum (6) für die Batterie (1) mit einer Längsachse (d) und einer Querschnittsfläche (D) senkrecht zur Längsachse (d) aufweist, wobei die Querschnittsfläche (D) des Aufnahmeraums (6) des Adapters (5) der Querschnittsfläche (B) der Batterie (1) entspricht und wobei die Querschnittsfläche (A) des Aufnahmeraums (4) des Prüfblocks (2) der Querschnittsfläche (C) des Adapters (5) entspricht.

7. Batterie-Prüfvorrichtung nach Anspruch 6, **dadurch gekennzeichnet, dass** der Prüfblock und/oder der Adapter (5) aus einem gut temperaturleitenden Material besteht, insbesondere aus Kupfer, Aluminium oder Stahl, vorzugsweise Edelstahl.

8. Batterie-Prüfvorrichtung nach Anspruch 6 oder 7, **dadurch gekennzeichnet, dass** die Mittel (3) zum Temperieren des Prüfblocks (2) Kanäle umfassen, die in den Prüfblock (2) eingearbeitet sind und welche zum Durchströmen mit einem temperierten Fluid ausgebildet sind.

9. Batterie-Prüfvorrichtung nach Anspruch 6 oder 7, **dadurch gekennzeichnet, dass** die Mittel (3) zum Temperieren des Prüfblocks (2) Heizelemente und Kühlelemente umfassen, die in den Prüfblock (2) eingesetzt sind.

10. Batterie-Prüfvorrichtung nach Anspruch 9, **dadurch gekennzeichnet, dass** die Heizelemente elektrische Heizstäbe sind.

11. Batterie-Prüfvorrichtung nach Anspruch 9, **dadurch gekennzeichnet, dass** die Kühlelemente Peltier-Elemente sind.

12. Batterie-Prüfvorrichtung nach einem der Ansprüche 6 bis 11, **dadurch gekennzeichnet, dass** der Prüfblock (2) zumindest teilweise von Isolationsmaterial umgeben ist.

13. Batterie-Prüfvorrichtung nach einem der Ansprüche 6 bis 12, **dadurch gekennzeichnet, dass** mindestens zwei Aufnahmeräume (4) im Prüfblock (2) angeordnet sind, welche thermisch voneinander isoliert sind.
